(19) Europäisches Patentamt / European Patent Office / Office européen des brevets

(11) **EP 2 790 189 B1**

(12) **FASCICULE DE BREVET EUROPEEN**

(45) Date de publication et mention
de la délivrance du brevet:
**03.02.2016 Bulletin 2016/05**

(51) Int Cl.:
**H01B 11/20** *(2006.01)*  **H01B 11/00** *(2006.01)*
**H01B 11/18** *(2006.01)*

(21) Numéro de dépôt: **14161215.0**

(22) Date de dépôt: **24.03.2014**

(54) **Cable de transmission de données destiné a l'industrie aéronautique**

Datenübertragungskabel für die Luftfahrtindustrie

Data-transmission cable for the aeronautical industry

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **08.04.2013 FR 1353136**

(43) Date de publication de la demande:
**15.10.2014 Bulletin 2014/42**

(73) Titulaire: **Nexans**
**75008 Paris (FR)**

(72) Inventeur: **Daumand, Thiery**
**35580 GUIGNEN (FR)**

(74) Mandataire: **Lenne, Laurence et al
Ipsilon Feray Lenne Conseil
Le Centralis
63, avenue du Général Leclerc
92340 Bourg-la-Reine (FR)**

(56) Documents cités:
**EP-A1- 0 802 543**      **JP-A- 2011 071 095**
**US-A1- 2005 029 006**

• **Nexans: "Complete, reliable cables range for
Aircraft Issue 8 -June 2011", , 8 juin 2011
(2011-06-08), pages 1-252, XP055091480, Extrait
de l'Internet: URL:http://www.nexans.fr/France/
2011/BD_NEXANS_catal_aircraft_EN.pdf[extrait
le 2013-12-04]**

## Description

L'invention concerne un câble de transmission à fils conducteurs en cuivre, destiné à l'industrie aéronautique, en particulier un câble pour application Ethernet.

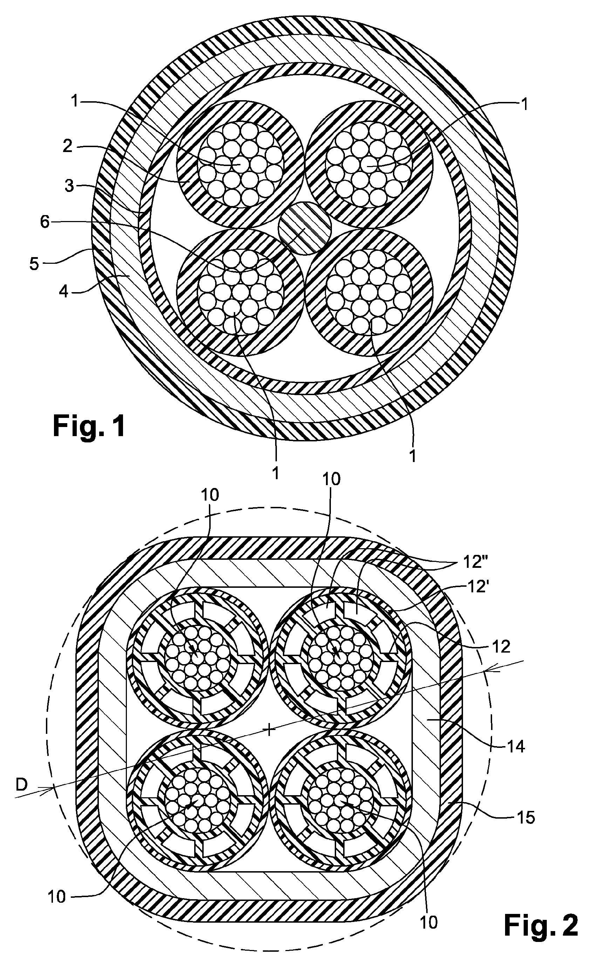

Un tel câble connu est commercialisé par la déposante sous la référence EN 3375-011 C KL et est représenté sur la figure 1.

De l'intérieur vers l'extérieur, ce câble comporte :

- un jonc central de support mécanique 6,
- quatre torons 1 toronnés autour de ce jonc central et constitués chacun de 19 fils conducteurs de cuivre revêtus d'argent, le diamètre nominal de chaque toron étant de 0,60 mm, et recouverts d'une couche isolante colorée 2 en fluoropolymère,
- un ruban séparateur 3 en polytétrafluoroéthylène (couramment connu sous son abréviation PTFE),
- un blindage 4 constitué d'un tissu métallique de fils tressés de cuivre revêtu d'argent et dont le diamètre des fils tressés est de 0,10 mm,
- une gaine extérieure 5 en fluoropolymère.

Le diamètre extérieur de ce câble est de l'ordre de 3,85 mm.

Par ailleurs, l'atténuation maximale à 25°C d'un tel câble est définie par la norme publiée par l'Association Européenne des Industries Aéronautiques (AECMA) de référence EN 3375-011 et publiée en septembre 2012.

Ces niveaux d'atténuation maximaux admissibles sont définis dans le tableau 4 de cette norme et sont :

| Fréquence (MHz) | Atténuation maximale du câble (dB/100 m) |
|---|---|
| 1,00 | 2,1 |
| 4,00 | 4,4 |
| 10,00 | 6,9 |
| 16,00 | 8,8 |
| 20,00 | 9,9 |
| 31,25 | 12,5 |
| 62,50 | 18 |
| 100,00 | 23,3 |

L'objet de l'invention est d'optimiser un tel câble en diminuant l'atténuation d'un câble de transmission de données à fils conducteurs en cuivre, destiné à l'industrie aéronautique.

Pour ce faire, l'invention propose un câble de transmission de données, comportant quatre torons constitués chacun de 19 fils conducteurs de cuivre et recouverts chacun d'une couche isolante, un blindage constitué d'un tissu métallique de cuivre et une gaine extérieure, caractérisé en ce que

- le diamètre de chaque dit toron est égal à 0,625 mm avec une tolérance de plus ou moins 0,007 mm,
- ladite couche isolante comporte un matériau aéré, cette aération représentant 40% de son volume total,
- il est dépourvu de jonc central de support mécanique desdits torons et de ruban de séparation autour desdits torons.

Outre une diminution de l'atténuation, le câble conforme à l'invention présente également une masse linéique totale maximale de 32 kg/km, particulièrement favorable.

Selon un mode de réalisation préféré, ladite couche isolante est pourvue d'alvéoles d'aération longitudinales.

Elle peut également être constituée d'un matériau isolant moussé, comme par exemple de l'éthylène-propylène fluoré (couramment connu sous son abréviation FEP), du per-fluoro-alkoxy ou du tétra-fluoro-éthylène d'éthylène (ETFE).

Elle peut également être constituée d'un matériau d'extrusion aérée, par exemple du polytétrafluor d'éthylène (PTFE).

Elle peut enfin être constituée d'un matériau rubané, par exemple en polytétrafluor d'éthylène basse densité (PTFE LD).

De préférence, ladite couche isolante est dépourvue de pigments de coloration et est revêtue d'une peau colorée.

Ladite peau colorée est de préférence d'une épaisseur d'environ 0,05 mm.

Ledit blindage constitué d'un tissu métallique comporte de préférence des fils tressés de diamètre d'environ 0,12 mm.

Lesdits fils conducteurs et lesdits fils tressés sont avantageusement revêtus d'argent.

De préférence, le revêtement d'argent desdits fils conducteurs est d'une épaisseur minimale de 1 micron.

Ladite gaine extérieure est avantageusement en éthylène tétrafluoroéthylène, également appelé poly(éthylène-co-tétrafluoroéthylène), couramment connu sous son abréviation ETFE.

L'invention est décrite ci-après plus en détail à l'aide d'une figure ne représentant qu'un mode de réalisation préféré de l'invention.

La figure 1 déjà précisée est une vue en coupe transversale d'un câble connu selon l'art antérieur.

La figure 2 est une vue schématique en coupe transversale d'un câble conforme à l'invention.

Comme représenté sur la figure 2, un câble de transmission de données destiné à l'industrie aéronautique, conforme à l'invention, comporte quatre torons 10 constitués de 19 fils conducteurs de cuivre revêtu d'argent et recouverts chacun d'une couche isolante 12, un blindage 14 constitué d'un tissu métallique de fils tressés de cuivre revêtu d'argent et entourant les quatre torons 10 et une gaine extérieure 15 entourant le blindage 15.

Le câble est dépourvu de jonc central de support mécanique des torons et de ruban de séparation autour des torons.

Le diamètre de chaque toron est égal à 0,625 mm avec une tolérance de plus ou moins 0,007 mm, chaque dit toron présentant une résistance ohmique linéique inférieure ou égale à 71,5 Ohm/km et une masse linéique inférieure ou égale à 2,44 kg/km.

Comme précisé dans la norme précédemment citée, de préférence, le revêtement d'argent a une épaisseur de 1 micron minimum, chaque toron présente un allongement de 10% minimum et une contrainte à la rupture de 220 MPa.

La couche isolante 12 est dépourvue de pigments de coloration et est revêtue d'une peau colorée 12', de préférence d'une épaisseur d'environ 0,05 mm.

La couche isolante comporte des alvéoles d'aération longitudinales 12" de section transversale trapézoïdale, régulièrement réparties et représentant 40% de son volume total et est constituée de fluorocarbone perfluorométhoxy (couramment connu sous son abréviation MFA). A titre d'exemple, il est utilisé le matériau dénommé « Hyflon PFA M640 » commercialisé par la société Solvay Solexis. Ce matériau présente une densité comprise entre 2,12 et 2,17 g/cm$^3$ et une température de fonctionnement de 255°C. Le diamètre extérieur de chaque toron 10 équipé uniquement de sa couche isolante est de 1,27 mm avec une tolérance de plus ou moins 0,03 mm.

La peau colorée 12' est en éthylène-propylène fluoré (couramment connu sous son abréviation FEP) qui est un copolymère d'hexafluoropropylène et de tétrafluoroéthylène. A titre d'exemple, il est utilisé le matériau dénommé « Teflon FEP 106-N » commercialisé par la société Dupont. Ce matériau présente une densité comprise entre 2,12 et 2,17 g/cm$^3$ et une température de fonctionnement de 205°C. Le diamètre extérieur de chaque toron 10 équipé de sa couche isolante 12 elle-même revêtue de la peau colorée 12' est de 1,37 mm avec une tolérance de plus ou moins 0,03 mm.

Le blindage 14 constitué d'un tissu métallique comporte des fils tressés de diamètre de 0,12 mm, avec une tolérance de plus ou moins 0,003 mm. Il présente 24 fuseaux, 4 fils par fuseau et un angle de tressage de 27°. Le diamètre extérieur nominal du blindage est d'environ 3,85 mm.

La gaine extérieure 15 est avantageusement en éthylène tétrafluoroéthylène (couramment connu sous son abréviation ETFE). A titre d'exemple, il est utilisé le matériau dénommé « Tefzel 207 » commercialisé par la société Dupont. Ce matériau présente une densité de 1,7 g/cm$^3$ et une température de fonctionnement de 150°C. Le diamètre total extérieur D du câble est de 4,3 mm avec une tolérance de plus ou moins 0,2 mm.

Un câble défini comme ci-dessus présente un niveau d'atténuation faible, particulièrement optimisé pour une fréquence du signal supérieure à 20 MHz, tout en restant limité à une fréquence du signal inférieure à 20 MHz.

Le tableau ci-dessous donne la marge de sécurité d'atténuation pour le câble connu EN 3375-011 C KL cité plus haut et pour un câble conforme à l'invention, cette marge de sécurité étant définie comme ci-dessous :

$$\text{marge de sécurité} = 100 \times [1 - (\text{plus grande valeur d'atténuation mesurée} / \text{atténuation maximale définie par la norme EN 3375-011})]$$

| Fréquence du signal (MHz) | Câble EN 3375-011 C KL | Câble selon l'invention |
|---|---|---|
| 1 | 19,7% | 12,4% |

(suite)

| Fréquence du signal (MHz) | Câble EN 3375-011 C KL | Câble selon l'invention |
|---|---|---|
| 4 | 9,8% | 6,6% |
| 10 | 3,2% | 3,0% |
| 16 | 2,6% | 2,6% |
| 20 | 2,5% | 2,8% |
| 31,25 | 1,9% | 2,7% |
| 62,5 | 0,4% | 2,9% |
| 100 | 0,5% | 4,1% |

**Revendications**

1. Câble de transmission de données, comportant quatre torons (10) constitués chacun de 19 fils conducteurs de cuivre et recouverts chacun d'une couche isolante (12), un blindage (14) constitué d'un tissu métallique de cuivre et une gaine extérieure (15), **caractérisé en ce que**

   - le diamètre de chaque dit toron (10) est égal à 0,625 mm avec une tolérance de plus ou moins 0,007 mm,
   - ladite couche isolante (12) comporte un matériau aéré, cette aération représentant 40% de son volume total,
   - il est dépourvu de jonc central de support mécanique desdits torons (10) et de ruban de séparation autour desdits torons (10).

2. Câble selon la revendication précédente, **caractérisé en ce que** ladite couche isolante (12) est pourvue d'alvéoles longitudinales d'aération (12").

3. Câble selon la revendication 1 ou 2, **caractérisé en ce que** ladite couche isolante (12) est dépourvue de pigments de coloration et est revêtue d'une peau colorée (12').

4. Câble selon la revendication précédente, **caractérisé en ce que** ladite peau colorée (12') est d'une épaisseur d'environ 0,05 mm.

5. Câble selon l'une des revendications précédentes, **caractérisé en ce que** ledit blindage (14) constitué d'un tissu métallique comporte des fils tressés de diamètre de 0,12 mm, avec une tolérance de plus ou moins 0,003 mm.

6. Câble selon la revendication précédente, **caractérisé en ce que** lesdits fils conducteurs et lesdits fils tressés sont revêtus d'argent.

7. Câble selon la revendication précédente, **caractérisé en ce que** le revêtement d'argent desdits fils conducteurs est d'une épaisseur minimale de 1 micron.

8. Câble selon l'une des revendications précédentes, **caractérisé en ce que** ladite gaine extérieure (15) est en tétrafluoroéthylène d'éthylène (ETFE).

**Patentansprüche**

1. Datenübertragungskabel, das vier Litzen (10), die jeweils aus 19 leitenden Kupferdrähten bestehen und jeweils von einer Isolationsschicht (12) bedeckt sind, eine Abschirmung (14), die aus einem Kupfermetallgewebe besteht und eine äußere Hülle (15) aufweist, **dadurch gekennzeichnet, dass**

   - der Durchmesser jeder Litze (10) gleich 0,625 mm ist mit einer Toleranz von mehr oder weniger als 0,007 mm,
   - die Isolationsschicht (12) ein belüftetes Material aufweist, wobei diese Belüftung 40 % ihres Gesamtvolumens ausmacht,
   - es keinen zentralen Stab für die mechanische Stützung der Litzen (10) und kein Separationsband um die Litzen (10) aufweist.

**2.** Kabel nach vorangehendem Anspruch, **dadurch gekennzeichnet, dass** die Isolationsschicht (12) mit länglichen Belüftungswaben (12") ausgestattet ist.

**3.** Kabel nach Anspruch 1 oder 2, **dadurch gekennzeichnet, dass** die Isolationsschicht (12) keine Farbpigment hat und mit einer farbigen Haut (12') bedeckt ist.

**4.** Kabel nach vorangehendem Anspruch, **dadurch gekennzeichnet, dass** die farbige Haut (12') eine Stärke von zirka 0,05 mm hat.

**5.** Kabel nach einem der vorangehenden Ansprüche, **dadurch gekennzeichnet, dass** die aus einem Metallgewebe bestehende Abschirmung (14) geflochtene Drähte mit einem Durchmesser von 0,12 mm mit einer Toleranz von mehr oder weniger als 0,003 mm aufweist.

**6.** Kabel nach vorangehendem Anspruch, **dadurch gekennzeichnet, dass** die leitenden Drähte und die geflochtenen Drähte mit Silber beschichtet sind.

**7.** Kabel nach vorangehendem Anspruch, **dadurch gekennzeichnet, dass** die Silberbeschichtung der leitenden Drähte eine minimale Stärke von 1 Mikron hat.

**8.** Kabel nach einem der vorangehenden Ansprüche, **dadurch gekennzeichnet, dass** die äußere Hülle (15) aus Ethylen-Tetrafluorethylen (ETFE) ist.

**Claims**

**1.** A data transmission cable, including strands (10) each consisting of 19 conductive copper wires and each covered with an insulating layer (12), a shielding (14) consisting of copper metal fabric and an outer sheath (15), **characterized in that**

    - the diameter of each said strand (10) is equal to 0.625 mm with a tolerance of plus or minus 0.007 mm,
    - said insulating layer (12) includes a ventilated material, ventilation representing 40% of its total volume,
    - it is without any central ring for mechanically supporting said strands (10) and any separation ribbon around said strands (10).

**2.** The cable according to the preceding claim, **characterized in that** said insulating layer (12) is provided with longitudinal ventilation cells (12")

**3.** The cable according to claim 1 or 2, **characterized in that** said insulating layer (12) is without any coloring pigments and is coated with a colored skin (12').

**4.** The cable according to the preceding claim, **characterized in that** said colored skin (12') has a thickness of about 0.05 mm.

**5.** The cable according to one of the preceding claims, **characterized in that** said shielding (14) consisting of a metal fabric includes braided wires with a diameter of 0.12 mm, with a tolerance of plus or minus 0.003 mm.

**6.** The cable according to the preceding claim, **characterized in that** said conductive wires and said braided wires are coated with silver.

**7.** The cable according to the preceding claim, **characterized in that** the silver coating of said conductive wires has minimum thickness of 1 micron.

**8.** The cable according to one of the preceding claims, **characterized in that** said external sheath (15) is in ethylene tetrafluoroethylene (ETFE).

**Fig. 1**

**Fig. 2**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3375011 A